# EUROPEAN PATENT APPLICATION

(11) **EP 2 781 953 A1**
(43) Date of publication of application: **24.09.2014**
(21) Application number: 14159006.7
(22) Date of filing: 12.03.2014
(51) Int. Cl.: G02F 1/1333

(54) **Display apparatus having a front cabinet secured to display module**

(30) Priority: 21.03.2013 JP 2013058926
(71) Applicant: Funai Electric Company Ltd, Daito-shi Osaka 574-0013 (JP)
(72) Inventor: Suzuki, Yuto, Daito-shi, Osaka 5740013 (JP); Morita, Shinji, Daito-shi, Osaka 5740013 (JP)
(74) Representative: Vigand, Philippe

(57) **Abstract**

A front cabinet 10 includes, on each long side thereof and at a location other than a corner region thereof, a rib member 13B that protrudes toward a display module. The front cabinet 10 includes, on each short side thereof and at a location other than a corner region thereof, a rib member 13A that protrudes toward a display module. The display module includes a hole 11A across from the rib member 13B that restricts movement thereof in the lengthwise direction of the long side of the front cabinet 10 and a hole 11A across from the rib member 13A that restricts movement thereof in the lengthwise direction of the short side of the front cabinet 10.

## Description

### Field

The present invention relates to display apparatuses for displaying images.

### Background

Display apparatuses that display images on a display panel, such as a liquid crystal television receiver, are conventionally known (for example, see Patent Literature (PTL) 1).

In such a conventional display apparatus, the display module and the front cabinet are kept from becoming misaligned by fixing the display module, including the display panel, and the front cabinet. By keeping the display module and the front cabinet from becoming misaligned, the problem of screen obstruction can be solved. Here, "screen obstruction" refers to an edge portion of the display panel becoming covered by the front cabinet as a result of the display panel and the front cabinet becoming misaligned, whereby a portion of the image displayed in the edge portion of the display panel becomes out of view.

### Citation List

### Patent Literature

[PTL 1] Japanese Unexamined Patent Application Publication No. 2000-181371

### Summary

### Technical Problem

In PTL 1, the front cabinet and the display module are fastened together by screws at the corner regions of the front cabinet. As such, when the front cabinet or the display module thermally expand and contract, this applies a large force to the portions where the screws are provided, and as a result, there is a problem that the screws or the areas around the screws on the front cabinet or the display module break. There are also instances when a large force is applied to the front cabinet or the display module due to variations in size of the front cabinet or the display module.

The present invention was conceived to solve the above-described problem and aims to provide a display apparatus that is capable of securing the display module to the front cabinet in a manner that is insusceptible to heat or variations in size.

### Solution to Problem

In order to achieve the above goal, one aspect of the display apparatus includes: a display module including a display panel; and a front cabinet that covers an outer peripheral portion of the display module from a front side of the display module, wherein the front cabinet includes on each long side thereof a first protrusion at a location other than a corner region of the front cabinet, the first protrusion protruding toward the display module, the front cabinet includes on each short side thereof a second protrusion at a location other than the corner region of the front cabinet, the second protrusion protruding toward the display module, and the display module includes a first restrictor across from the first protrusion and a second restrictor across from the second protrusion, the first restrictor restricting movement of the first protrusion in a lengthwise direction of the long side of the front cabinet and the second restrictor restricting movement of the second protrusion in a lengthwise direction of the short side of the front cabinet.

With this configuration, movement of the display module with respect to the front cabinet is restricted except for in positions at the corner regions of the front cabinet. As such, even if the front cabinet and/or the display module thermally expands or contracts, since they expand or contract in a direction from the protrusion toward the corner regions, the areas around the first protrusion and the second protrusion are resistant to influence from expansion and contraction, and similarly resistant to influence from variations in size. This makes it possible to secure the display module to the front cabinet in a manner that is insusceptible to heat or variations in size.

For example, the first protrusion may include a first rib, and the first restrictor may include a first hole that accommodates the first rib and is of a size that restricts movement of the first rib in the lengthwise direction of the long side of the front cabinet and allows for play of the first rib in the lengthwise direction of the short side of the front cabinet.

With this configuration, movement of the first ribs provided on the long sides of the front cabinet is restricted in the lengthwise direction of the long sides of the front cabinet, but not restricted in the lengthwise direction of the short sides of the front cabinet. As such, even if the front cabinet and/or the display module thermally expand or contract in the lengthwise direction of the short sides or there are variations in size in the lengthwise direction of the short sides, a large force is not applied to the first ribs.

Moreover, the second protrusion may include a second rib, and the second restrictor may include a second hole that accommodates the second rib and is of a size that restricts movement of the second rib in the lengthwise direction of the short side of the front cabinet and allows for play of the second rib in the lengthwise direction of the long side of the front cabinet.

With this configuration, movement of the second ribs provided on the short sides of the front cabinet is restricted in the lengthwise direction of the short sides of the front cabinet, but not restricted in the lengthwise direction of the long sides of the front cabinet. As such, even if the front cabinet and/or the display module thermally expand or contract in the lengthwise direction of the long sides or there are variations in size in the lengthwise direction of the long sides, a large force is not applied to the second ribs.

Moreover, the first protrusion may include a first rib, and the first restrictor may include a first recess that accommodates the first rib and is of a size that restricts movement of the first rib in the lengthwise direction of the long side of the front cabinet and allows for play of the first rib in the lengthwise direction of the short side of the front cabinet.

With this configuration, movement of the first ribs provided on the long sides of the front cabinet is restricted in the lengthwise direction of the long sides of the front cabinet, but not restricted in the lengthwise direction of the short sides of the front cabinet. As such, even if the front cabinet and/or the display module thermally expand or contract in the lengthwise direction of the short sides or there are variations in size in the lengthwise direction of the short sides, a large force is not applied to the first ribs.

Moreover, the second protrusion may include a second rib, and the second restrictor may include a second recess that accommodates the second rib and is of a size that restricts movement of the second rib in the lengthwise direction of the short side of the front cabinet and allows for play of the second rib in the lengthwise direction of the long side of the front cabinet.

With this configuration, movement of the second ribs provided on the short sides of the front cabinet is restricted in the lengthwise direction of the short sides of the front cabinet, but not restricted in the lengthwise direction of the long sides of the front cabinet. As such, even if the front cabinet and/or the display module thermally expand or contract in the lengthwise direction of the long sides or there are variations in size in the lengthwise direction of the long sides, a large force is not applied to the second ribs.

Moreover, the first protrusion may include a first recess, and the first restrictor may include a first rib that fits in the first recess and is of a size that restricts movement of the first recess in the lengthwise direction of the long side of the front cabinet and allows for play of the first recess in the lengthwise direction of the short side of the front cabinet.

With this configuration, movement of the first recesses provided on the long sides of the front cabinet is restricted in the lengthwise direction of the long sides of the front cabinet, but not restricted in the lengthwise direction of the short sides of the front cabinet. As such, even if the front cabinet and/or the display module thermally expand or contract in the lengthwise direction of the short sides or there are variations in size in the lengthwise direction of the short sides, a large force is not applied to the first recesses.

Moreover, the second protrusion may include a second recess, and the second restrictor may include a second rib that fits in the second recess and is of a size that restricts movement of the second recess in the lengthwise direction of the short side of the front cabinet and allows for play of the second recess in the lengthwise direction of the long side of the front cabinet.

With this configuration, movement of the second recesses provided on the short sides of the front cabinet is restricted in the lengthwise direction of the short sides of the front cabinet, but not restricted in the lengthwise direction of the long sides of the front cabinet. As such, even if the front cabinet and/or the display module thermally expand or contract in the lengthwise direction of the long sides or there are variations in size in the lengthwise direction of the long sides, a large force is not applied to the second recesses.

Moreover, the first protrusions may be located a same distance from an end of the long sides of the front cabinet, and the second protrusions may be located a same distance from an end of the short sides of the front cabinet.

With this configuration, when force is applied to the protrusions, equal force is applied to the two first protrusions, and equal force is applied to the two second protrusions.

Moreover, the first protrusion may be located at a center of the long side of the front cabinet in a lengthwise direction, and the second protrusion may be located at a center of the short side of the front cabinet in a lengthwise direction.

### Advantageous Effects

With the present invention, it is possible to provide a display apparatus that is capable of securing the display module to the front cabinet in a manner that is insusceptible to heat or variations in size.

### Brief Description of Drawings

[FIG. 1] FIG. 1 illustrates the display apparatus from the front.
[FIG. 2] FIG. 2 is a cross section illustrating the relevant components in the display apparatus at the line A-A shown in FIG. 1.
[FIG. 3] FIG. 3 is an illustration of the front cabinet as seen from the back.
[FIG. 4] FIG. 4 is a cross section of the front cabinet and the bezel at the line B-B shown in FIG. 1 or the line C-C shown in FIG. 3.
[FIG. 5] FIG. 5 is an illustration of the front cabinet as seen from the back.
[FIG. 6] FIG. 6 is an illustration of the front cabinet as seen from the back.
[FIG. 7] FIG. 7 is a cross section showing the relevant components in the display apparatus at the line B-B shown in FIG. 1.
[FIG. 8] FIG. 8 is a cross section showing the relevant components in the display apparatus at the line A-A shown in FIG. 1.
[FIG. 9] FIG. 9 illustrates the molded frame as seen from the front of the display apparatus.
[FIG. 10] FIG. 10 is an illustration of the front cabinet as seen from the back of the display apparatus.
[FIG. 11] FIG. 11 is a cross section showing the relevant components in the display apparatus at the line B-B shown in FIG. 1.
[FIG. 12] FIG. 12 is a cross section showing the relevant components in the display apparatus at the line A-A shown in FIG. 1.
[FIG. 13] FIG. 13 is an illustration of the front cabinet as seen from the back of the display apparatus.
[FIG. 14] FIG. 14 illustrates the molded frame as seen from the front of the display apparatus.

### Description of Embodiments

Hereinafter, certain exemplary embodiments are described in greater detail with reference to the accompanying Drawings. It should be noted the embodiments described below show specific examples of the present invention. The numerical values, shapes, materials, structural elements, the arrangement and connection of the structural elements etc. shown in the following exemplary embodiments are mere examples, and therefore do not limit the present invention, the scope of which is defined in the appended Claims. As such, among the structural elements in the following exemplary embodiments, structural elements not recited in any one of the independent claims defining the most generic part of the inventive concept are described as structural elements of a preferable embodiment, and are not absolutely necessary to overcome the problem according to the present invention.

### Embodiment 1

### (Overall Configuration of the Display Apparatus)

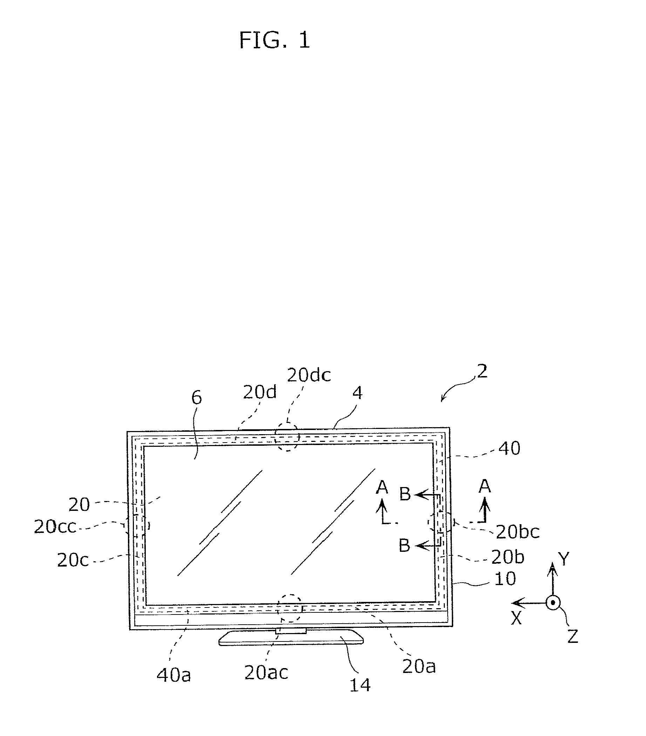

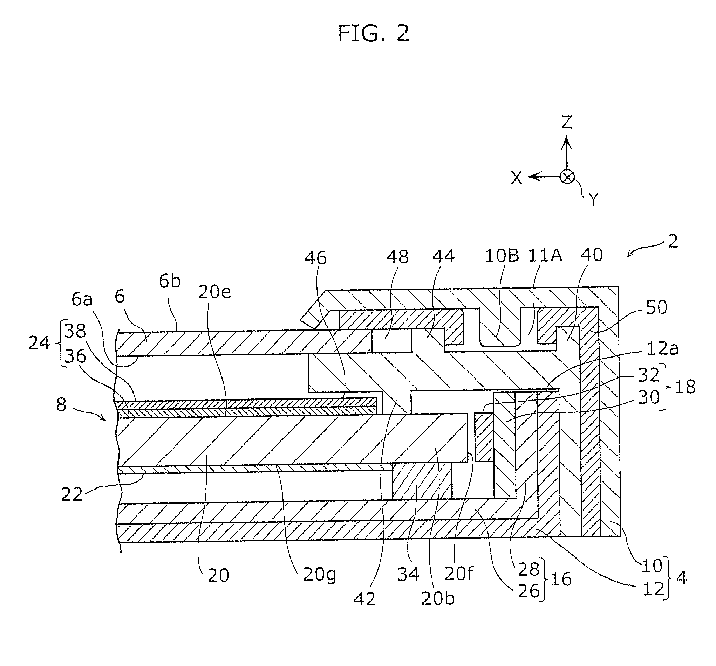

First, the overall configuration of the display apparatus according to Embodiment 1 is described with reference to FIG. 1 and FIG. 2. FIG. 1 illustrates the display apparatus from the front. FIG. 2 is a cross section showing the relevant components in the display apparatus at the line A-A shown in FIG. 1.

As is illustrated in FIG. 1 and FIG. 2, the display apparatus 2 includes a housing 4, a liquid crystal panel 6 (which includes the display panel) provided in the housing 4, and a backlight unit 8 provided in the housing 4. The display apparatus 2 according to Embodiment 1 is a liquid crystal television receiver equipped with the edge-lit backlight unit 8. However, the backlight unit 8 is not limited to an edge-lit type backlight unit.

A front cabinet 10 and a rear cabinet 12 are put together to form the housing 4. The front cabinet 10 is formed in the shape of a frame and covers the outer peripheral portion of the liquid crystal panel 6. The rear cabinet 12 is arranged facing the back surface 6a of the liquid crystal panel 6. The rear cabinet 12 includes a rectangular opening 12a to accommodate the liquid crystal panel 6. A stand 14 for supporting the housing 4 from below is attached to the bottom end portion of the rear cabinet 12.

The backlight unit 8 is supported by the internal surface side of the rear cabinet 12. The backlight unit 8 is for emitting light toward the back surface 6a of the liquid crystal panel 6. The backlight unit 8 includes a heat sink 16, an LED bar 18, a light guide plate 20, a reflective sheet 22, and an optical sheet 24.

The heat sink 16 includes a flat heat dissipation portion 26 and an attachment portion 28 which extends substantially vertical from one end portion of the heat dissipation portion 26 toward the liquid crystal panel 6. In other words, the heat sink 16 has a cross section that is substantially L-shaped. The heat dissipation portion 26 is attached to the internal surface side of the rear cabinet 12 with screws (not shown in the drawings). The attachment portion 28 positionally corresponds to, among four peripheral edge portions 20a through 20d of the light guide plate 20, the peripheral edge portion 20b, which extends in the lengthwise direction of the short side. It should be noted that the heat sink 16 is made from a metal having high thermal conductivity, such as aluminum.

The LED bar 18 includes a wiring substrate 30 and a plurality of LEDs 32 (The plurality of LEDs 32 constitute a light source). The wiring substrate 30 has an elongated plate-like shape. The LEDs 32 are arranged in a line in the longitudinal direction of the wiring substrate 30 and spaced apart from each other. The plurality of LEDs 33 are each, for example, chip-type LEDs. The wiring substrate 30 is attached to the attachment portion 28 of the heat sink 16 with double sided tape (not shown in the drawings) having heat transfer properties. It should be noted that the wiring substrate 30 is made from a metal having high thermal conductivity, such as aluminum.

The light guide plate 20 is rectangular and supported by the heat dissipation portion 26 of the heat sink 16 via a cushion 34 formed from, for example, a rubber material. It should be noted that the cushion 34 positionally corresponds to the outer peripheral portion of the light guide plate 20. A main surface 20e of the light guide plate 20 is arranged to face the back surface 6a of the liquid crystal panel 6. A side surface 20f of the light guide plate 20 is arranged to face the plurality of LEDs 32. It should be noted that the light guide plate 20 is made from, for example, acrylic resin.

The reflective sheet 22 is arranged so as to cover the back surface 20g of the light guide plate 20 (in other words, arranged to cover the surface on the opposite side of the main surface 20e). The reflective sheet 22 has an optical function of reflecting, toward the main surface 20e, light entering from the side surface 20f of the light guide plate 20.

The optical sheet 24 includes a diffusion sheet 36 and a lens sheet 38. The diffusion sheet 36 and the lens sheet 38, while mutually superimposed, are arranged so as to cover the main surface 20e of the light guide plate 20. The diffusion sheet 36 has an optical function of diffusing light exiting from the main surface 20e of the light guide plate 20. The lens sheet 38 has an optical function of guiding the light diffused by the diffusion sheet 36 toward the back surface 6a of the liquid crystal panel 6.

A molded frame 40 for supporting the four peripheral edge portions of the liquid crystal panel 6 via the back surface 6a of the liquid crystal panel 6 is attached to the opening 12a of the rear cabinet 12 with screws (not shown in the drawings). In Embodiment 1, the molded frame 40 is frame-shaped. The back surface of the molded frame 40 (in other words, the surface of the molded frame 40 on the light guide plate 20 side) is provided with a first rib portion 42, and the front surface of the molded frame 40 (in other words, the surface of the molded frame 40 on the liquid crystal panel 6 side) is provided with a second rib portion 44.

The first rib portion 42 protrudes toward the main surface 20e of the light guide plate 20. The first rib portion 42 is provided to form a gap 46 between the molded frame 40 and the four peripheral edge portions 20a through 20d of the light guide plate 20. The four peripheral edge portions of both the diffusion sheet 36 and the lens sheet 38 are arranged in the gap 46. In Embodiment 1, at the portions of the molded frame 40 corresponding to the three peripheral edge portions 20b through 20d of the light guide plate 20, the first rib portion 42 is in continuous contact with the main surface 20e of the light guide plate 20 along the three peripheral edge portions 20b through 20d. Moreover, at the portion 40a (hereinafter referred to as the support member 40a) of the molded frame 40 that corresponds to the peripheral edge portion 20a of the light guide plate 20 closest to the stand 14, the first rib portion 42 (which is included in the rib portion) is in discontinuous contact with the main surface 20e of the light guide plate 20 along the peripheral edge portion 20a of the light guide plate 20. A more specific description of the configuration of the first rib portion 42 provided on the support member 40a will be given later.

The second rib portion 44 protrudes toward a bezel 50 (to be described later). The second rib portion 44 is provided to form a gap 48 between the molded frame 40 and the bezel 50. Four peripheral edge portions of the liquid crystal panel 6 are arranged in the gap 48.

The liquid crystal panel 6 is rectangular and the four peripheral edge portions thereof are supported by the inner peripheral portion (the portion of the molded frame 40 inward relative to the second rib portion 44) of the molded frame 40. Light from the backlight unit 8 shines on the back surface 6a of the liquid crystal panel 6 whereby an image is displayed on the liquid crystal panel 6. The four peripheral edge portions on the front surface 6b (in other words, the surface of the liquid crystal panel 6 on the opposite side of the back surface 6a) of the liquid crystal panel 6 are covered by the bezel 50. The bezel 50 has the shape of, for example, a frame, and is fixed to the molded frame 40 by screws (not shown in the drawings). This sandwiches the four peripheral edge portions of the liquid crystal panel 6 between the bezel 50 and the molded frame 40.

It should be noted that the front cabinet 10 is attached to the rear cabinet 12 by screws (not shown in the drawings) so that the front cabinet 10 covers the bezel 50 and the molded frame 40.

### (Attachment Structure of the Front Cabinet 10 and the Bezel 50)

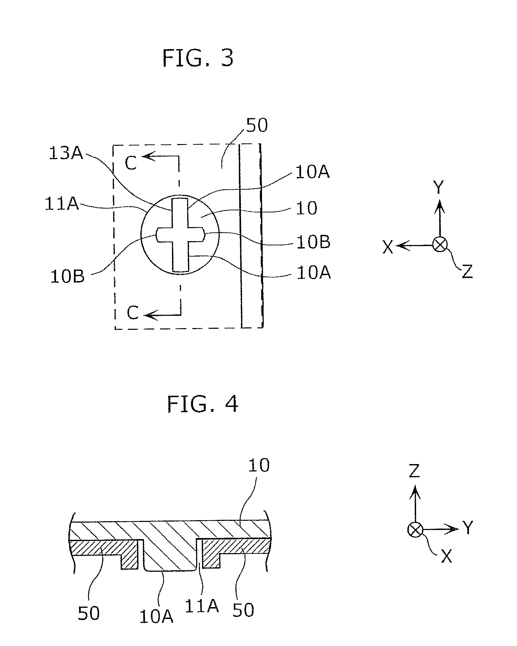

Next, the attachment structure of the front cabinet 10 and the bezel 50 will be described with reference to FIG. 3 and FIG. 4. In the following description, the liquid crystal panel 6, the bezel 50, and the molded frame 40 are collectively referred to as a "display module".

FIG. 3 is an illustration of the front cabinet 10 as seen from the back, at a center region 20bc located approximately in the center of the peripheral edge portion 20b illustrated in FIG. 1 in the lengthwise direction thereof. FIG. 4 is a cross section of the front cabinet 10 and the bezel 50 at the line B-B shown in FIG. 1 or the line C-C shown in FIG. 3.

The front cabinet 10 includes a rib member 13A (first protrusion) that protrudes toward the display module. The rib member 13A includes a rib 10A that extends in the lengthwise direction of the short sides of the front cabinet 10 (Y axis direction) and a rib 10B that extends in the lengthwise direction of the long sides of the front cabinet 10 (X axis direction). A hole 11A that accommodates the rib member 13A is formed on the bezel 50 across from the rib member 13A. The hole 11A has, for example, a circular shape.

As is illustrated in FIG. 3 and FIG. 4, the width of the rib 10A in the Y axis direction and the width of the hole 11A in the Y axis direction are substantially equal. As such, movement of the front cabinet 10 in the Y axis direction is restricted by the hole 11A. Conversely, as is illustrated in FIG. 3 and FIG. 2, the width of the rib 10B in the X axis direction is narrower than the width of the hole 11A in the X axis direction. This allows for play, of the front cabinet 10, in the X axis direction. In other words, the front cabinet 10 can move to a certain degree in the X axis direction at the center region 20bc. It should be noted that the rib 10B is provided in the rib member 13A to reinforce the rib 10A, but provision of thereof in the rib member 13A is not absolutely necessary.

The front cabinet 10 and the bezel 50 also have the same configuration illustrated in FIG. 3 at a center region 20cc located approximately in the center of the peripheral edge portion 20c illustrated in FIG. 1 in the lengthwise direction thereof as well.

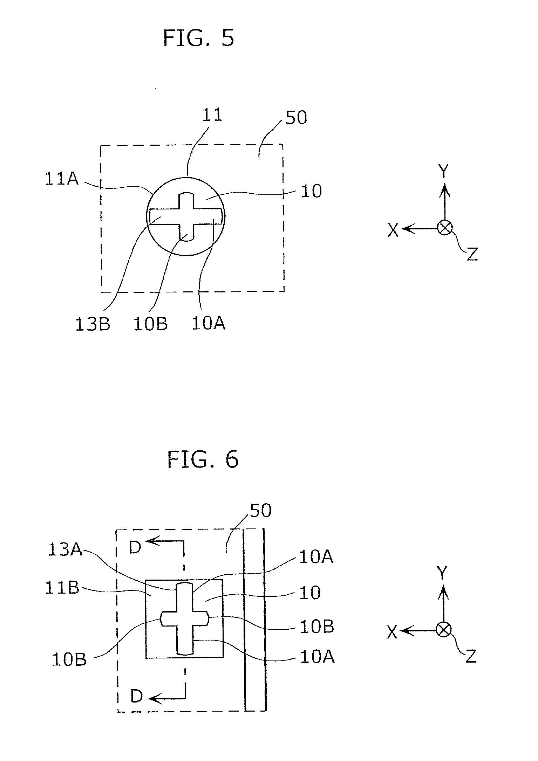

Moreover, as is illustrated in FIG. 5, a rib member 13B is formed on the front cabinet 10 at a center region 20ac located approximately in the center of the peripheral edge portion 20a illustrated in FIG. 1 in the lengthwise direction thereof as well as at a center region 20dc located approximately in the center of the peripheral edge portion 20d illustrated in FIG. 1 in the lengthwise direction thereof. Moreover, the hole 11A that accommodates the rib member 13B is formed on the bezel 50 across from the rib member 13B. The rib member 13B includes the rib 10A that extends in the X axis direction and the rib 10B that extends in the Y axis direction. The width of the rib 10A in the X axis direction and the width of the hole 11A in the X axis direction are substantially equal. As such, movement of the front cabinet 10 in the X axis direction is restricted by the hole 11A. Conversely, the width of the rib 10B in the Y axis direction is narrower than the width of the hole 11A in the Y axis direction. This allows for play, of the front cabinet 10, in the Y axis direction. In other words, the front cabinet 10 can move to a certain degree in the Y axis direction at the center region 20ac and the center region 20dc.

### (Advantageous Effect)

As described above, movement of the display module with respect to the front cabinet 10 is restricted except for in positions at the corner regions of the front cabinet 10. As such, even if the front cabinet 10 and/or the display module thermally expands or contracts, since they expand or contract in a direction from the rib member 13A and/or the rib member 13B toward the corner regions, the areas around the rib member 13A and the rib member 13B are resistant to influence from expansion and contraction, and similarly resistant to influence from variations in size. This makes it possible to secure the display module to the front cabinet 10 in a manner that is insusceptible to heat or variations in size.

It should be noted that the rib members 13A arranged in the center region 20bc and the center region 20cc do not restrict movement in the X axis direction. As such, even if the front cabinet 10 and/or the display module thermally expand or contract in the X axis direction or there are variations in size in the X axis direction, a large force is not applied to the rib members 13A.

Likewise, the rib members 13B arranged in the center region 20ac and the center region 20dc do not restrict movement in the Y axis direction. As such, even if the front cabinet 10 and/or the display module thermally expand or contract in the Y axis direction or there are variations in size in the Y axis direction, a large force is not applied to the rib members 13B.

### Embodiment 2

The bezel 50 in the display apparatus according to Embodiment 2 is provided with a different shaped hole than Embodiment 1. All other constituent elements are the same as in Embodiment 1.

FIG. 6 is an illustration of the front cabinet 10 as seen from the back, at the center region 20bc illustrated in FIG. 1.

The front cabinet 10 is provided with the same rib member 13A as in Embodiment 1. A hole 11B that accommodates the rib member 13A is formed on the bezel 50 across from the rib member 13A. The hole 11B has, for example, a quadrilateral shape.

The width of the rib 10A in the Y axis direction and the width of the hole 11B in the Y axis direction are substantially equal. As such, movement of the front cabinet 10 in the Y axis direction is restricted by the hole 11B. Conversely, as is illustrated in FIG. 3 and FIG. 2, the width of the rib 10B in the X axis direction is narrower than the width of the hole 11B in the X axis direction. This allows for play, of the front cabinet 10, in the X axis direction.

It should be noted that the front cabinet 10 and the bezel 50 also have the same configuration illustrated in FIG. 6 at the center region 20cc as well.

Moreover, at the center region 20ac and the center region 20dc, the front cabinet 10 and the bezel 50 are configured to use the hole 11B as a substitute for the hole 11A shown in FIG. 5.

With this, Embodiment 2 has the same advantageous effects as Embodiment 1.

### Embodiment 3

In Embodiments 1 and 2, the bezel 50 is provided with the holes. In Embodiment 3, a variation of the display apparatus in which the molded frame 40 is provided with a recess will be described.

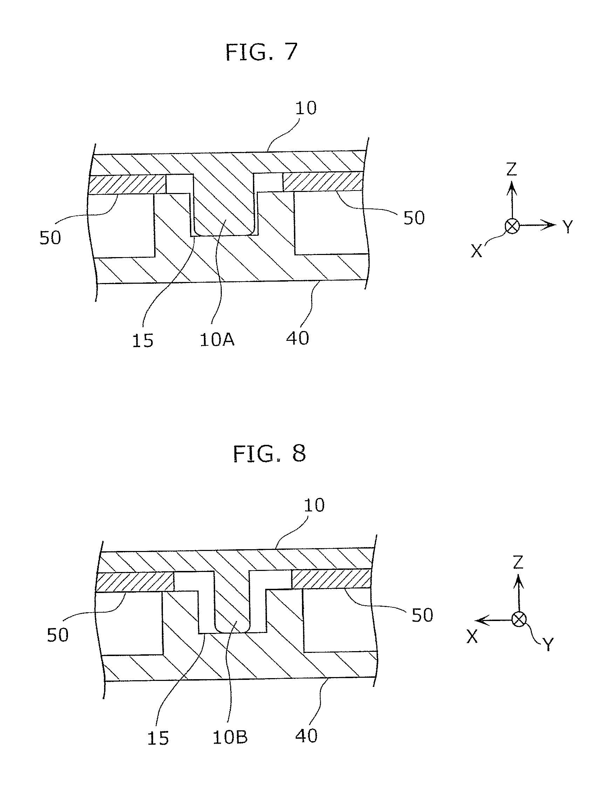

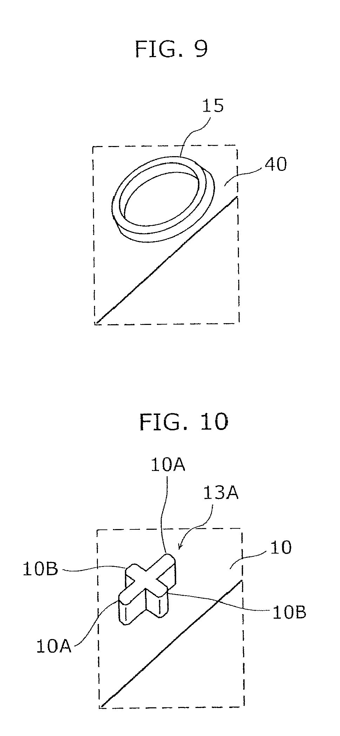

FIG. 7 is a cross section showing the relevant components in the display apparatus 2 at the line B-B shown in FIG. 1. The cross section illustrated only includes the front cabinet 10, the bezel 50, and the molded frame 40. FIG. 8 is a cross section showing the relevant components in the display apparatus 2 at the line A-A shown in FIG. 1. The cross section illustrated only includes the front cabinet 10, the bezel 50, and the molded frame 40. FIG. 9 illustrates the molded frame 40 as seen from the front of the display apparatus 2, at the center region 20bc. FIG. 10 is an illustration of the front cabinet 10 as seen from the back of the display apparatus 2, at the center region 20bc.

As is illustrated, the front cabinet 10 is provided with the same rib member 13A as in Embodiments 1 and 2. A circular recess 15 that accommodates the rib member 13A is formed on the molded frame 40 across from the rib member 13A.

As is illustrated in FIG. 7, FIG. 9, and FIG. 10, the width of the rib 10A in the Y axis direction and the width of the recess 15 in the Y axis direction are substantially equal. As such, movement of the front cabinet 10 in the Y axis direction is restricted by the recess 15. Conversely, as is illustrated in FIG. 8 through FIG. 10, the width of the rib 10B in the X axis direction is narrower than the width of the recess 15 in the X axis direction. This allows for play, of the front cabinet 10, in the X axis direction. In other words, the front cabinet 10 can move to a certain degree in the X axis direction at the center region 20bc.

The front cabinet 10 and the molded frame 40 also have the same configuration illustrated in FIG. 7 through FIG. 10 at the center region 20cc illustrated in FIG. 1 as well.

Likewise, the front cabinet 10 and the molded frame 40 also have the same configuration illustrated in FIG. 7 through FIG. 10 at the center region 20ac and the center region 20dc illustrated in FIG. 1 as well. However, the orientations of the rib 10A and the rib 10B are different. More specifically, the rib 10A is formed so that the lengthwise direction thereof is parallel to the X axis direction and the rib 10B is formed so that the lengthwise direction thereof is parallel to the Y axis direction. As such, at the center region 20ac and the center region 20dc, movement of the front cabinet 10 in the X axis direction is restricted, and room for play of the front cabinet 10 in the Y axis direction is provided.

With this, Embodiment 3 has the same advantageous effects as Embodiment 1.

### Embodiment 4

In Embodiment 3, the front cabinet 10 is provided with rib members, and the molded frame 40 is provided with recesses. In Embodiment 4, a variation of the display apparatus in which the molded frame 40 is provided with rib members and the front cabinet 10 is provided with recesses will be discussed.

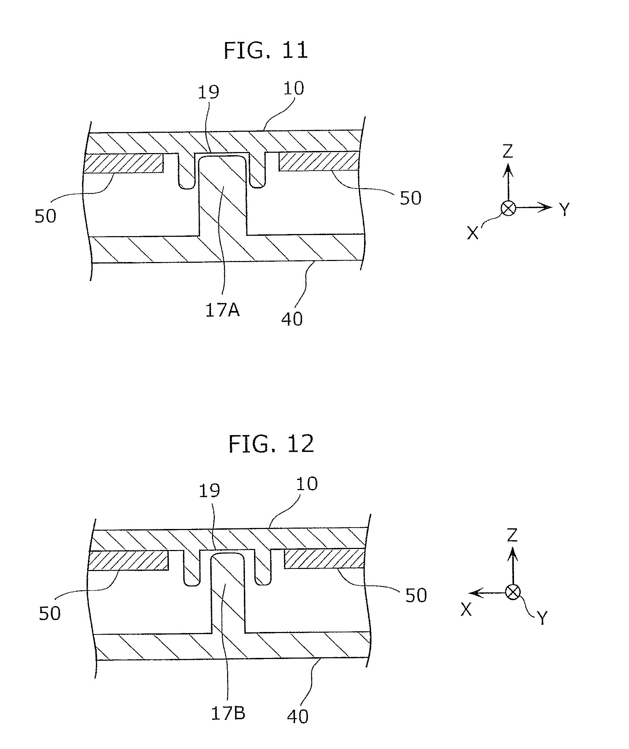

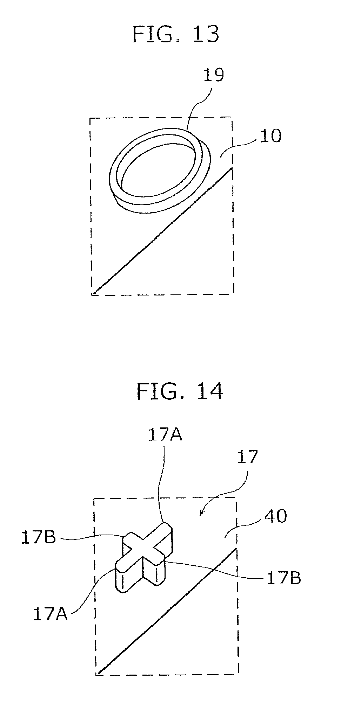

FIG. 11 is a cross section showing the relevant components in the display apparatus 2 at the line B-B shown in FIG. 1. The cross section illustrated only includes the front cabinet 10, the bezel 50, and the molded frame 40. FIG. 12 is a cross section showing the relevant components in the display apparatus 2 at the line A-A shown in FIG. 1. The cross section illustrated only includes the front cabinet 10, the bezel 50, and the molded frame 40. FIG. 13 is an illustration of the front cabinet 10 as seen from the back of the display apparatus 2, at the center region 20bc. FIG. 14 illustrates the molded frame 40 as seen from the front of the display apparatus 2, at the center region 20bc.

As is illustrated, the front cabinet 10 is provided with a cylindrical recess 19. A rib member 17 that fits into the recess 19 is formed on the molded frame 40. The rib member 17 includes a rib 17A that extends in the Y axis direction and a rib 17B that extends in the X axis direction.

As is illustrated in FIG. 11, FIG. 13, and FIG. 14, the width of the rib 17A in the Y axis direction and the width of the recess 19 in the Y axis direction are substantially equal. As such, movement of the front cabinet 10 in the Y axis direction is restricted by the rib member 17. Conversely, as is illustrated in FIG. 12 through FIG. 14, the width of the rib 17B in the X axis direction is narrower than the width of the recess 19 in the X axis direction. This allows for play, of the front cabinet 10, in the X axis direction. In other words, the front cabinet 10 can move to a certain degree in the X axis direction at the center region 20bc.

The front cabinet 10 and the molded frame 40 also have the same configuration illustrated in FIG. 11 through FIG. 14 at the center region 20cc illustrated in FIG. 1 as well.

Likewise, the front cabinet 10 and the molded frame 40 also have the same configuration illustrated in FIG. 11 through FIG. 14 at the center region 20ac and the center region 20dc illustrated in FIG. 1 as well. However, the orientations of the rib 17A and the rib 17B are different. More specifically, the rib 17A is formed so that the lengthwise direction thereof is parallel to the X axis direction and the rib 17B is formed so that the lengthwise direction thereof is parallel to the Y axis direction. As such, at the center region 20ac and the center region 20dc, movement of the front cabinet 10 in the X axis direction is restricted, and room for play of the front cabinet 10 in the Y axis direction is provided.

With this, Embodiment 4 has the same advantageous effects as Embodiment 1.

The display apparatus has hereinbefore been described according to the embodiments of the present invention, but the present invention is not limited to these embodiments.

In Embodiments 1 though 4, rib members and holes or recesses are provided at the center regions 20ac, 20bc, 20cc, and 20dd to restrict movement of the molded frame 40, but the locations of the rib members etc. are not limited to these locations; they may be located at other regions except for the corner regions of the front cabinet 10. It should be noted the rib members etc. provided on the peripheral edge portion 20a and the peripheral edge portion 20d are preferably provided the same distance from one end of the peripheral edge portion 20a and the peripheral edge portion 20d. Similarly, the rib members etc. provided on the peripheral edge portion 20b and the peripheral edge portion 20c are preferably provided the same distance from one end of the peripheral edge portion 20b and the peripheral edge portion 20c.

Moreover, the shape of the recess described in Embodiments 3 and 4 is not limited to a cylindrical shape, and may be rectangular. Moreover, a hole may be provided in the molded frame 40 or the front cabinet 10 instead of the recess.

Furthermore, the above embodiments may be arbitrarily combined.

Although the present invention has been described and illustrated in detail, it is clearly understood that the same is by way of example only and is not to be taken by way of limitation, the scope of the present invention being limited only by the terms of the appended claims.

### Industrial Applicability

The present invention is applicable as a playback device such as a television that reproduces a television broadcast.

### Reference Signs List

2 display apparatus
4 housing
6 liquid crystal panel
6a back surface
6b front surface
8 backlight unit
10 front cabinet
10A, 10B, 17A, 17B rib
11A, 11B hole
12 rear cabinet
12a opening
13A, 13B, 17 rib member
14 stand
15, 19 recess
16 heat sink
18 LED bar
20 light guide plate
20a, 20b, 20c, 20d peripheral edge portion
20ac, 20bc, 20cc, 20dc center region
20e main surface
20f side surface
20g back surface
22 reflective sheet
24 optical sheet
26 heat dissipation portion
28 attachment portion
30 wiring substrate
32 LED
34 cushion
36 diffusion sheet
38 lens sheet
40 molded frame
40a, 40Aa, 40Ba support member
42 first rib portion
44 second rib portion
46, 48 gap
50 bezel

## Claims

1. A display apparatus comprising:
a display module including a display panel; and
a front cabinet that covers an outer peripheral portion of the display module from a front side of the display module,
wherein the front cabinet includes on each long side thereof a first protrusion at a location other than a corner region of the front cabinet, the first protrusion protruding toward the display module,
the front cabinet includes on each short side thereof a second protrusion at a location other than the corner region of the front cabinet, the second protrusion protruding toward the display module, and
the display module includes a first restrictor across from the first protrusion and a second restrictor across from the second protrusion, the first restrictor restricting movement of the first protrusion in a lengthwise direction of the long side of the front cabinet and the second restrictor restricting movement of the second protrusion in a lengthwise direction of the short side of the front cabinet.

2. The display apparatus according to Claim 1,
wherein the first protrusion includes a first rib, and
the first restrictor includes a first hole that accommodates the first rib and is of a size that restricts movement of the first rib in the lengthwise direction of the long side of the front cabinet and allows for play of the first rib in the lengthwise direction of the short side of the front cabinet.

3. The display apparatus according to Claim 1 or 2,
wherein the second protrusion includes a second rib, and
the second restrictor includes a second hole that accommodates the second rib and is of a size that restricts movement of the second rib in the lengthwise direction of the short side of the front cabinet and allows for play of the second rib in the lengthwise direction of the long side of the front cabinet.

4. The display apparatus according to Claim 1,
wherein the first protrusion includes a first rib, and
the first restrictor includes a first recess that accommodates the first rib and is of a size that restricts movement of the first rib in the lengthwise direction of the long side of the front cabinet and allows for play of the first rib in the lengthwise direction of the short side of the front cabinet.

5. The display apparatus according to Claim 1 or 4,
wherein the second protrusion includes a second rib, and
the second restrictor includes a second recess that accommodates the second rib and is of a size that restricts movement of the second rib in the lengthwise direction of the short side of the front cabinet and allows for play of the second rib in the lengthwise direction of the long side of the front cabinet.

6. The display apparatus according to Claim 1,
wherein the first protrusion includes a first recess, and
the first restrictor includes a first rib that fits in the first recess and is of a size that restricts movement of the first recess in the lengthwise direction of the long side of the front cabinet and allows for play of the first recess in the lengthwise direction of the short side of the front cabinet.

7. The display apparatus according to Claim 1 or 6,
wherein the second protrusion includes a second recess, and
the second restrictor includes a second rib that fits in the second recess and is of a size that restricts movement of the second recess in the lengthwise direction of the short side of the front cabinet and allows for play of the second recess in the lengthwise direction of the long side of the front cabinet.

8. The display apparatus according to any one of Claims 1 to 7,
wherein the first protrusions are located a same distance from an end of the long sides of the front cabinet, and
the second protrusions are located a same distance from an end of the short sides of the front cabinet.

9. The display apparatus according to Claim 8,
wherein the first protrusion is located at a center of the long side of the front cabinet in a lengthwise direction, and
the second protrusion is located at a center of the short side of the front cabinet in a lengthwise direction.
